# EUROPEAN PATENT APPLICATION

(11) **EP 4 207 574 A1**
(43) Date of publication of application: **05.07.2023**
(21) Application number: 22217360.1
(22) Date of filing: 30.12.2022
(51) Int. Cl.: H02M 7/5387, H02M 7/483, H02M 7/487, H02M 7/00, H01L 25/07, H05K 7/20, H01G 9/26

(54) **POWER CONVERTER**

(30) Priority: 31.12.2021 CN 202111671665
(71) Applicant: DELTA ELECTRONICS (SHANGHAI) CO., LTD, Shanghai 201209 (CN)
(72) Inventor: QIAO, Lifeng, SHANGHAI, 201209 (CN); LOU, Dehai, SHANGHAI, 201209 (CN); LIU, Teng, SHANGHAI, 201209 (CN); YING, Jianping, SHANGHAI, 201209 (CN); DAI, Zhiqiang, SHANGHAI, 201209 (CN)
(74) Representative: Cabinet Beau de Loménie

(57) **Abstract**

A power converter includes a PCB (1) having opposing first and second sides (11, 12), and a plurality of first commutation units and first capacitor unit disposed on the PCB. Each first commutation unit includes first and second discrete component (Q1, Q2). The second end of the first discrete component (Q1) is electrically coupled to the first end of the second discrete component (Q2), and the first capacitor unit (Ca) is electrically coupled to the first ends of the first discrete components (Q1) and the second ends of the second discrete components (Q2) in the plurality of first commutation units, respectively. The first and second discrete components (Q1, Q2) in the plurality of first commutation units are arranged in a row. The first and second discrete components (Q1, Q2) in each first commutation unit form a commutation loop together with the first capacitor unit (Ca).

## Description

### TECHNICAL FIELD

The present application relates to the technical field of power electronics, and more particularly, to a kind of power converter.

### BACKGROUND

With the popularization of global renewable energy sources and the rapid development of the electric vehicle industry, energy storage technology will become a key factor for promoting energy development, and the rapid development of energy storage demand puts forward higher requirements for the design of power converters in energy storage systems.

Conventional power converters include IGBT modules or SiC MOS modules, etc., when the modules are used as switching devices, there are usually problems of large size, especially the difficulty in reduction of the height of the modules and also local overheating and difficulty in heat dissipation.

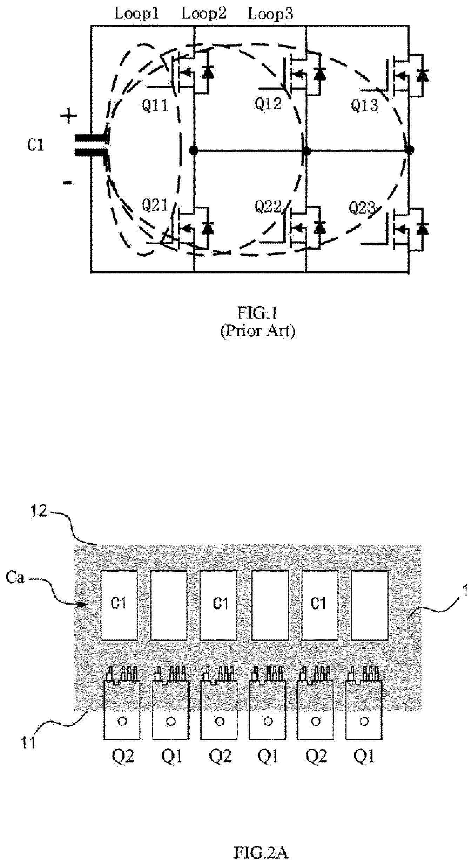

In addition, in order to increase the power level of the converter, the design solution of interleaved connection of multi-phase converters or parallel connection of devices is usually adopted. In the conventional solution of the parallel-connection of devices, the devices connected in parallel are placed together, a half-bridge circuit topology as shown in FIG. 1 includes a bus capacitor C1, an upper arm and a lower arm, wherein the upper arm includes switching devices Q11, Q12, and Q13 connected in parallel, and the lower arm includes switching devices Q21, Q22, and Q23 connected in parallel. In the solution of the devices connected in parallel, commutation loops 1, 2, and 3 are far away from identical, which will lead to large voltage stress on the switching devices and poor current balance on the switching devices connected in parallel.

### SUMMARY

The object of the present invention is to provide a power converter with a small and symmetrical commutation loop and a design beneficial for heat dissipation.

The object of the present application is to provide a power converter with a small and symmetrical commutation loop and a design beneficial for heat dissipation.

According to an aspect of the present application, a power converter includes a printed circuit board (hereinafter "PCB") having opposing first and second sides, and a plurality of first commutation units and first capacitor unit disposed on the PCB. Each of the first commutation units includes a first discrete component and a second discrete component. The second end of the first discrete component is electrically coupled to a first end of the second discrete component, and the first capacitor unit is electrically coupled to first ends of the first discrete components and second ends of the second discrete components in the plurality of first commutation units, respectively. Wherein the first discrete components and the second discrete components in the plurality of first commutation units are arranged in a row, and the first discrete component and the second discrete component in each of the first commutation units form a commutation loop together with the first capacitor unit.

The present application has at least the following advantages and beneficial effects: in the power converter of the present application, the commutation units do not include any modules, but comprise a plurality of discrete components, which allows flexible location of the discrete components and facilitates the reduction of an overall height of the power converter; further, the first discrete component and the second discrete component in each of the first commutation units form a commutation loop together with the first capacitor unit, so that the commutation loop is smaller and symmetrical, the first discrete components and the second discrete components in the plurality of first commutation units are arranged in a row, the first discrete component and the second discrete component in each first commutation unit operate in a complementary control manner, when the plurality of discrete components are arranged in a row, it may avoid the concentration of the plurality of discrete components that generate heat, thus preventing local overheating and facilitating the heat dissipation.

### BRIEF DESCRIPTION OF THE DRAWINGS

The above and other features and advantages of the present application will become more apparent from the detailed description of example embodiments thereof with reference to the accompanying drawings.
FIG. 1 is a schematic diagram of a commutation loop of a conventional power converter.
FIG. 2A is a structural schematic diagram of a first embodiment of a power converter of the present application.
FIG. 2B is a topology diagram of a first commutation unit in the first embodiment of the power converter of the present application.
FIG. 3A is a structural schematic diagram of a second embodiment of a power converter of the present application.
FIG. 3B is a topology diagram of the second embodiment of the power converter of the present application.
FIG. 3C is another structural schematic diagram of the second embodiment of the power converter of the present application.
FIG. 4A is a structural schematic diagram of a third embodiment of a power converter of the present application.
FIG. 4B is a topology diagram of the third embodiment of the power converter of the present application.
FIG. 4C is another structural schematic diagram of the third embodiment of the power converter of the present application;.
FIG. 5A is a structural schematic diagram of a fourth embodiment of a power converter of the present application.
FIG. 5B is a topology diagram of the fourth embodiment of the power converter of the present application.
FIG. 5C is another structural schematic diagram of the fourth embodiment of the power converter of the present application.
FIG. 6A is a structural schematic diagram of a fifth embodiment of a power converter of the present application.
FIG. 6B is a topology diagram of the fifth embodiment of the power converter of the present application.
FIG. 6C is another structural schematic diagram of the fifth embodiment of the power converter of the present application.
FIG. 7A is an exploded perspective view of a power converter of the present application.
FIG. 7B is an assembly perspective view of the power converter of the present application.
FIG. 7C is a perspective view of an enclosed cavity in a power converter of the present application.
FIG. 7D is a perspective view of a protective housing in a power converter of the present application.
FIG. 8 is a schematic diagram illustrating a primary air duct and a secondary air duct in a power converter of the present application.

### DETAILED DESCRIPTION

Exemplary embodiments will now be described more comprehensively with reference to the accompanying drawings. However, the exemplary embodiments can be implemented in various forms and should not be construed as being limited to the embodiments set forth herein; on the contrary, these embodiments are provided so that the present application will be through and complete and the concept of the exemplary embodiments will be fully conveyed to those skilled in the art. The same or like structures will be denoted by the same reference numbers throughout the drawings, and thus detailed descriptions thereof will be omitted.

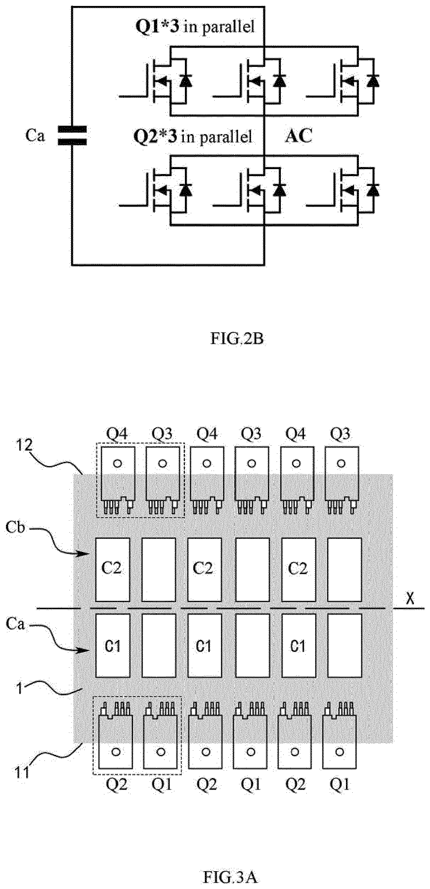

Referring to FIGS. 2A and 2B, FIG. 2A is a structural schematic diagram of a first embodiment of a power converter of the present application and FIG. 2B is a topology diagram of a first commutation unit in the first embodiment of the power converter of the present application.

As shown in FIG. 2A, the first embodiment of the power converter of the present application includes a PCB 1, a plurality of first commutation units disposed on the PCB 1 and first capacitor unit Ca, the capacitor in the first capacitor unit Ca, for example, is DC bus capacitor, flying capacitor, or input capacitor. The PCB 1 has opposing first side 11 and second side 12.

Each first commutation unit includes a first discrete component Q1 and a second discrete component Q2. In each first commutation unit, a second end of the first discrete component Q1 is electrically coupled to a first end of the second discrete component Q2. The first capacitor unit Ca is electrically coupled to a first end of the first discrete component Q1 and a second end of the second discrete component Q2 in each first commutation unit, respectively. Specifically, pins of the capacitors in the first capacitor unit Ca, and pins of the first discrete component Q1 and the second discrete component Q2 in each commutation unit are soldered on the PCB 1. The pins of the capacitors in the first capacitor unit Ca are electrically connected to the first discrete component Q1 and the second discrete component Q2 in the corresponding first commutation unit via wiring on the PCB 1.

The first discrete components Q1 and the second discrete components Q2 in the plurality of first commutation units are arranged in a row on the PCB 1. The discrete components arranged in a row may be located on the first side 11 of the PCB 1, and of course, may also be located on the second side 12 of the PCB 1. A center line of the discrete components arranged in a row may be parallel to an edge of the first side 11 or the second side 12 of the PCB 1. When the discrete components arranged in a row are located on the first side 11 of the PCB 1, the first capacitor unit Ca is close to the second side 12 of the PCB 1; and when the discrete components arranged in a row are located on the second side 12 of the PCB 1, the first capacitor unit Ca is close to the first side 11 of the PCB 1. The first capacitor unit Ca and the first discrete components Q1 and the second discrete components Q2 in the plurality of first commutation units are located on the same surface of the PCB 1.

In the embodiment, the first capacitor unit Ca includes a plurality of first capacitors C1, wherein the plurality of first capacitors C1 may be connected in parallel. The plurality of first capacitors C1 may be arranged in a row on the PCB 1 and a center line of the first capacitors C1 arranged in a row may be parallel to the center line of the discrete components arranged in a row. In some other embodiments, the first capacitor unit Ca may be a single capacitor.

The first capacitor unit forms a commutation loop together with the first discrete component Q1 and the second discrete component Q2 in each first commutation unit, respectively, so as to form a plurality of relatively independent commutation loops. The plurality of commutation loops of the plurality of first commutation units are substantively identical and are symmetrical to each another, thus a voltage stress of the individual discrete components is small and the current balance in the power converter is excellent.

In an embodiment, the first discrete components Q1 in the plurality of first commutation units are electrically coupled in parallel and the second discrete components Q2 in the plurality of first commutation units are electrically coupled in parallel.

As shown in FIG. 2A, in the first embodiment, the first discrete components Q1 and the second discrete components Q2 in the plurality of first commutation units are alternately arranged in a row. That is to say, in the plurality of discrete components arranged in a row, one second discrete component Q2 is sandwiched between any two adjacent first discrete components Q1 and one first discrete component Q1 is sandwiched between any two adjacent second discrete components Q2. The power converter further includes a heat sink, the pins of the first discrete components Q1 and the second discrete components Q2 in the plurality of first commutation units are soldered on the PCB 1, bodies of the first discrete components Q1 and the second discrete components Q2 in the plurality of first commutation units are parallel to the PCB 1, first surfaces of the bodies of the first discrete components Q1 and the second discrete components Q2 in the plurality of first commutation units are close to the PCB 1, second surfaces of the bodies of the first discrete components Q1 and the second discrete components Q2 in the plurality of first commutation units are attached to a surface of the heat sink, and the heat sink is used to dissipate heat of the first discrete components Q1 and the second discrete components Q2 in the plurality of first commutation units. The first discrete component Q1 and the second discrete component Q2 in each first commutation unit operate in a complementary control manner and the discrete components may generate a lot of heat during operation. When the plurality of first discrete components Q1 and the plurality of second discrete components Q2 are alternately arranged, the temperature on the heat sink will be relatively uniform, which effectively avoids local overheating and is beneficial to reducing the difficulty of heat dissipation design and improving the heat dissipation efficiency.

In other embodiments, the plurality of first discrete components Q1 and the plurality of second discrete components Q2 may not necessarily be alternately arranged, for example, there may be a situation where two first discrete components Q1 are adjacent to each other or two second discrete components Q2 are adjacent to each other.

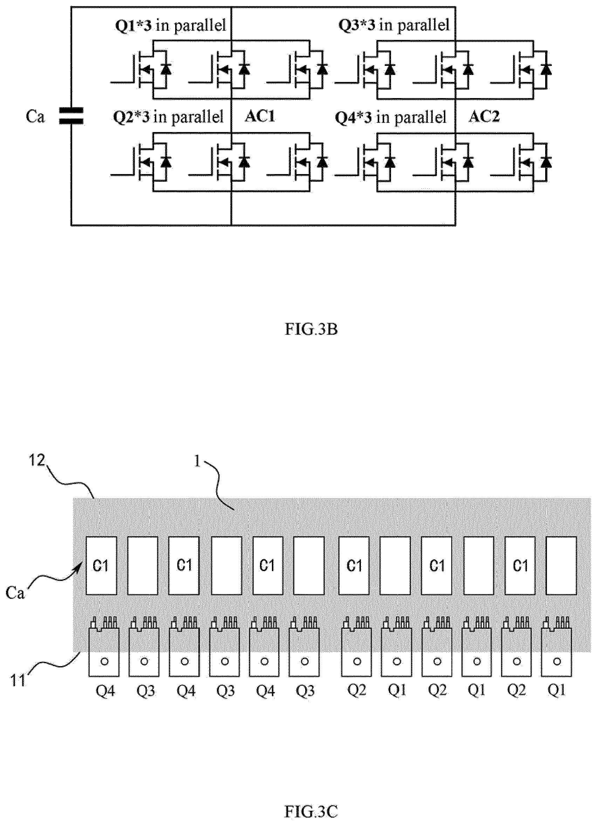

Referring to FIGS. 3A, 3B, and 3C, FIG. 3A is a structural schematic diagram of a second embodiment of a power converter of the present application, FIG. 3B is a topology diagram of the second embodiment of the power converter of the present application, and FIG. 3C is another structural schematic diagram of the second embodiment of the power converter of the present application.

As shown in FIG. 3A, the second embodiment of the power converter of the present application is different from the first embodiment of the power converter of the present application in that it further includes a plurality of second commutation units disposed on the PCB 1. The plurality of second commutation units and the plurality of first commutation units are symmetrically arranged relative to a center line X of the PCB 1.

Each second commutation unit includes a third discrete component Q3 and a fourth discrete component Q4. The first capacitor unit Ca forms a commutation loop together with the third discrete component Q3 and the fourth discrete component Q4 in each second commutation unit, respectively. The third discrete components Q3 and the fourth discrete components Q4 in the plurality of second commutation units are arranged in a row on the PCB 1.

In the second embodiment, the third discrete components Q3 and the fourth discrete components Q4 in the plurality of second commutation units are alternately arranged in a row. In some other embodiments, the plurality of third discrete components Q3 and the plurality of fourth discrete components Q4 may also be arranged in other manners.

As shown in FIG. 3A, the first capacitor unit Ca is disposed in the middle of the PCB 1 and the discrete components are disposed on both sides of the first capacitor unit Ca. In detail, all the first discrete components Q1 and the second discrete components Q2 are located on the first side 11 of the PCB 1 and all the third discrete components Q3 and the fourth discrete components Q4 are located on the second side 12 of the PCB 1. That is to say, the first commutation units and the second commutation units are symmetrically disposed on the PCB 1, the first commutation units are disposed on the lower half of the PCB 1 and the second commutation units are disposed on the upper half of the PCB 1. The first capacitor unit Ca may include a plurality of first capacitors C1 and the plurality of first capacitors C1 may be arranged in two rows arranged side by side on the PCB 1. The first capacitors C1 in each row are close to the discrete components connected thereto, so that the commutation loop formed by the discrete components in each commutation unit and the corresponding first capacitor C1 has a minimum path, that is, the commutation loop formed by the discrete components in each commutation unit and the corresponding first capacitor C1 (as close as possible to the commutation unit) has a minimum path. As shown in FIG. 3C, all of the first discrete components Q1 and the second discrete components Q2 and all of the third discrete components Q3 and the fourth discrete components Q4 are arranged in a row and are disposed on the first side 11 of the PCB 1, and the first capacitor unit Ca is close to the second side 12 of the PCB 1. That is to say, the first commutation units and the second commutation units are symmetrically disposed on the PCB 1, the first commutation units are disposed on the right half of the PCB 1 and the second commutation units are disposed on the left half of the PCB 1. The first capacitor unit Ca may include a plurality of first capacitors C1 and the plurality of first capacitors C1 may be arranged in a row on the PCB 1. The first capacitors C1 are close to the discrete components connected thereto, so that a commutation loop formed by the discrete components in each commutation unit and the corresponding first capacitor C1 (as close as possible to the commutation unit) has a minimum path.

As shown in FIG. 3B, the first capacitor Ca is electrically coupled to a first end of the third discrete component Q3 and a second end of the fourth discrete component Q4 in each second commutation unit, respectively, and a second end of the third discrete component Q3 and a first end of the fourth discrete component Q4 are electrically coupled in each second commutation unit.

The first end of the third discrete component Q3 is electrically coupled to the first end of the first discrete component Q1 and the second end of the fourth discrete component Q4 is electrically coupled to the second end of the second discrete component Q2, thereby forming a full-bridge circuit topology.

In the second embodiment, the third discrete components Q3 in the plurality of second commutation units are electrically coupled in parallel and the fourth discrete components Q4 in the plurality of second commutation units are electrically coupled in parallel.

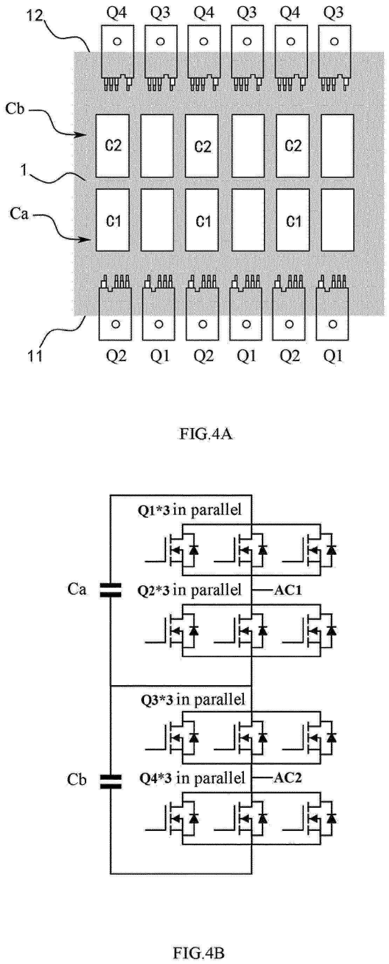

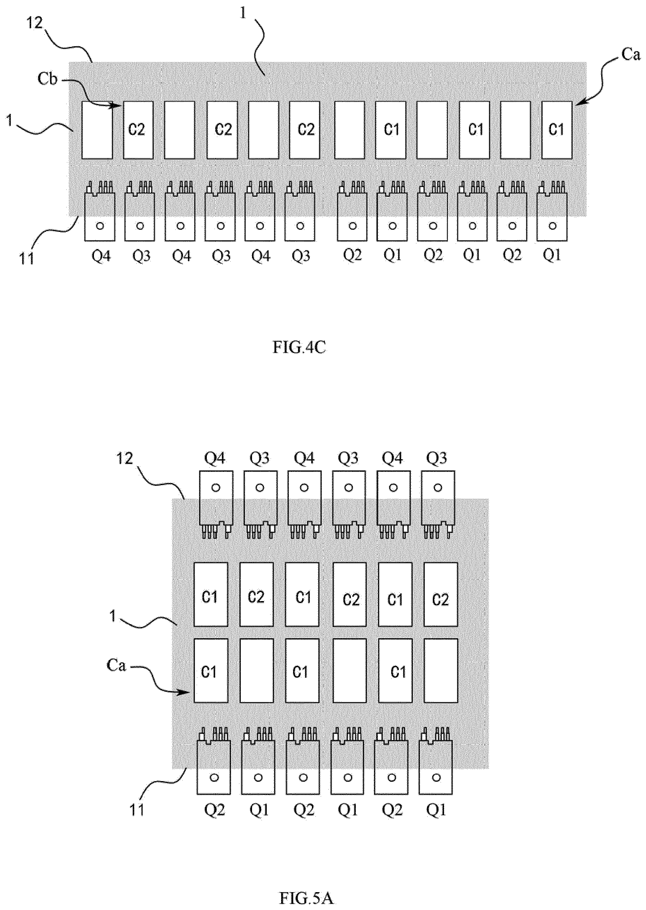

Referring to FIGS. 4A, 4B and 4C, FIG. 4A is a structural schematic diagram of a third embodiment of a power converter of the present application, FIG. 4B is a topology diagram of the third embodiment of the power converter of the present application, and FIG. 4C is another structural schematic diagram of the third embodiment of the power converter of the present application.

As shown in FIG. 4A, the third embodiment of the power converter of the present application is different from the first embodiment of the power converter of the present application in that it further includes a plurality of second commutation units and a second capacitor unit Cb disposed on the PCB 1. The plurality of second commutation units and the plurality of first commutation units are symmetrically disposed.

Each second commutation unit includes a third discrete component Q3 and a fourth discrete component Q4, and the second capacitor unit Cb forms a commutation loop together with the third discrete component Q3 and the fourth discrete component Q4 in each second commutation unit, respectively. The third discrete components Q3 and the fourth discrete components Q4 in the plurality of second commutation units are arranged in a row.

In the third embodiment, the third discrete components Q3 and the fourth discrete components Q4 in the plurality of second commutation units are alternately arranged in a row. In some other embodiments, the plurality of third discrete components Q3 and fourth discrete components Q4 may also be arranged in other manners.

As shown in FIG. 4A, the first capacitor unit Ca and the second capacitor unit Cb are disposed in the middle of the PCB 1 and the discrete components are disposed on both sides of the first capacitor unit and the second capacitor unit. In detail, all of the first discrete components Q1 and the second discrete components Q2 are located on the first side 11 of the PCB 1 and all of the third discrete components Q3 and the fourth discrete components Q4 are located on the second side 12 of the PCB 1. The first capacitor unit Ca may include a plurality of first capacitors C1 and the second capacitor unit Cb may include a plurality of second capacitors C2. The first capacitors C1 are arranged in a row, and are disposed side by side with the second capacitors C2 which are also arranged in a row. That is to say, the first commutation units and the second commutation units are symmetrically disposed relative to the first capacitor unit and the second capacitor unit on the PCB 1, the first commutation units are disposed on the lower half of the PCB 1, and the second commutation units are disposed on the upper half of the PCB 1. In the embodiment, the plurality of first capacitors C1 may be arranged in a row on the PCB 1, and the plurality of second capacitors C2 may be arranged in a row on the PCB 1. The first capacitors C1 are disposed side by side with the second capacitors C2. The first capacitors C1 arranged in a row are close to the first discrete component Q1 and the second discrete component Q2 in each first commutation unit connected thereto, and the second capacitors C2 arranged in a row are close to the third discrete component Q3 and the fourth discrete component Q4 in each second commutation unit connected thereto, so that a commutation loop formed by the discrete components in each first commutation unit and the corresponding first capacitor C1 (as close as possible to the first commutation unit) has a minimum path and a commutation loop formed by the discrete components in each second commutation unit and the corresponding second capacitor C2 (as close as possible to the second commutation unit) has a minimum path.

As shown in FIG. 4C, all of the first discrete components Q1 and the second discrete components Q2 and all of the third discrete components Q3 and the fourth discrete components Q4 are arranged in a row and are located on the first side 11 of the PCB 1, the first capacitor unit Ca and the second capacitor unit Cb are arranged in a row and are located between the second side 12 of the PCB 1 and the discrete components. That is to say, the first commutation units and the second commutation units are symmetrically disposed on the PCB 1, the first commutation units are disposed on the right half of the PCB 1 and the second commutation units are disposed on the left half of the PCB 1. The first capacitor unit Ca may include a plurality of first capacitors C1 and the plurality of first capacitors C1 may be arranged in a row on the PCB 1, and the second capacitor unit Cb may include a plurality of second capacitors C2 and the plurality of second capacitors C2 may be arranged in a row on the PCB 1. The plurality of first capacitors C1 and the plurality of second capacitors C2 are arranged in a row on the PCB 1. The first capacitors C1 are close to the first discrete component Q1 and the second discrete component Q2 in each first commutation unit connected thereto, so that a commutation loop formed by the first discrete component Q1 and the second discrete component Q2 in each first commutation unit and the corresponding first capacitor C1 (as close as possible to the first commutation unit) has a minimum path; and the second capacitors C2 are close to the third discrete component Q3 and the fourth discrete component Q4 in each second commutation unit connected thereto, so that a commutation loop formed by the third discrete component Q3 and the fourth discrete component Q4 in each second commutation unit and the corresponding second capacitor C2 (as close as possible to the second commutation unit) has a minimum path.

As shown in FIG. 4B, a second end of the third discrete component Q3 and a first end of the fourth discrete component Q4 in each second commutation unit are electrically coupled and the second capacitor unit Cb is electrically coupled to a first end of the third discrete components Q3 and a second end of the fourth discrete component Q4 in each second commutation unit, respectively.

The first capacitor unit Ca and the second capacitor unit Cb are electrically coupled in series, and a second end of the second discrete component Q2 in each first commutation unit is electrically coupled to the first end of the third discrete component Q3 in each second commutation unit, thereby forming a bridge arm series circuit topology.

In the third embodiment, the plurality of third discrete components Q3 in the plurality of second commutation units are electrically coupled in parallel and the plurality of fourth discrete components Q4 in the plurality of second commutation units are electrically coupled in parallel.

Other structures of the third embodiment of the power converter of the present application are basically the same as those of the first embodiment, and will not be repeated here.

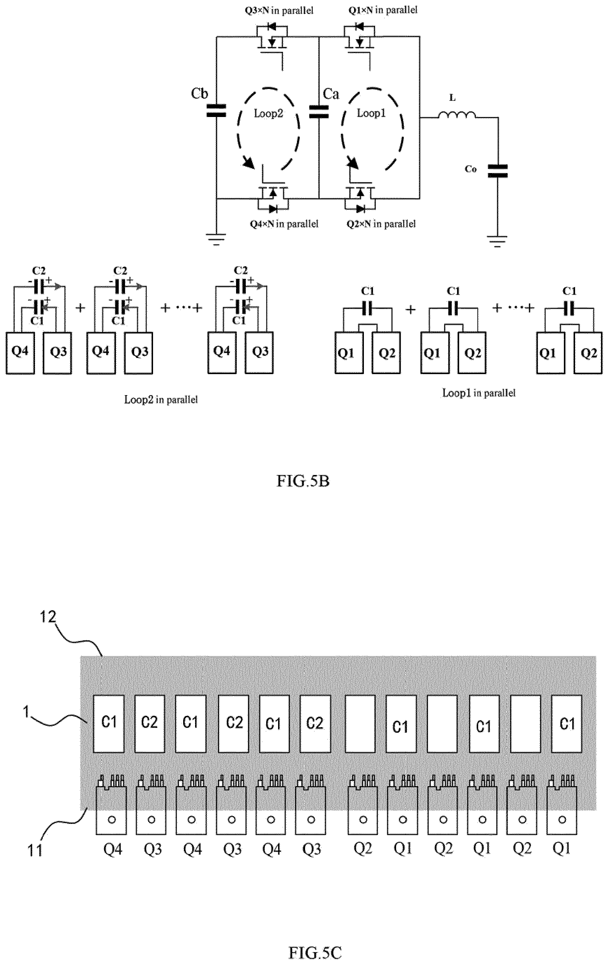

Referring to FIGS. 5A, 5B, and 5C, FIG. 5A is a structural schematic diagram of a fourth embodiment of the power converter of the present application, FIG. 5B is a topology diagram of the fourth embodiment of power converter of the present application, and FIG. 5C is another structural schematic diagram of the fourth embodiment of the power converter of the present application.

Referring to FIG. 5A, FIG. 5A is a structural schematic diagram of a fourth embodiment of a power converter of the present application.

As shown in FIG. 5A, the fourth embodiment of the power converter of the present application is different from the first embodiment in that it further includes a plurality of second commutation units and a second capacitor unit Cb disposed on the PCB 1. The plurality of second commutation units and the plurality of first commutation units are symmetrically disposed.

Each second commutation unit includes a third discrete component Q3 and a fourth discrete component Q4, and the first capacitor unit and the second capacitor unit form a commutation loop together with the third discrete component Q3 and the fourth discrete component Q4 in each second commutation unit, respectively. The third discrete components Q3 and the fourth discrete components Q4 in the plurality of second commutation units are arranged in a row.

In the fourth embodiment, the third discrete components Q3 and the fourth discrete components Q4 in the plurality of second commutation units are alternately arranged in a row. In some other embodiments, the plurality of third discrete components Q3 and fourth discrete components Q4 may also be arranged in other manners.

As shown in FIG. 5A, the first capacitor unit Ca and the second capacitor unit Cb are disposed in the middle of the PCB 1 and the discrete components are disposed on both sides of the first capacitor unit and the second capacitor unit. In detail, all of the first discrete components Q1 and the second discrete components Q2 are located on the first side 11 of the PCB 1 and all of the third discrete components Q3 and the fourth discrete components Q4 are located on the second side 12 of the PCB 1. The first capacitor unit Ca includes a plurality of first capacitors C1 and the second capacitor unit Cb includes a plurality of second capacitors C2. The first capacitor C1 and the second capacitor C2 are disposed side by side. That is to say, the first commutation units and the second commutation units are symmetrically disposed on the PCB 1, the first commutation units are disposed on the lower half of the PCB 1 and the second commutation units are disposed on the upper half of the PCB 1. In the fourth embodiment, a first part of the plurality of first capacitors C1 may be arranged in a row on the PCB 1 and a second part of the plurality of first capacitors C1 and the plurality of second capacitors C2 may be alternately arranged in a row on the PCB 1. The first part of the plurality of first capacitors C1 are close to the first discrete component Q1 and the second discrete component Q2 in each first commutation unit connected thereto, and the plurality of second capacitors C2 and the second part of the plurality of first capacitors C1 are close to the third discrete component Q3 and the fourth discrete component Q4 in each second commutation unit connected thereto, so that a commutation loop formed by the discrete components in each first commutation unit and the corresponding first capacitor C1 (as close as possible to the first commutation unit) has a minimum path, and a commutation loop formed by the discrete components in each second commutation unit, the corresponding first capacitor C1 and the corresponding second capacitor C2 (as close as possible to the second commutation unit) has a minimum path.

As shown in FIG. 5C, all of the first discrete components Q1 and the second discrete components Q2 and all of the third discrete components Q3 and the fourth discrete components Q4 are arranged in a row and are located on the first side 11 of the PCB 1, and the first capacitor unit Ca and the second capacitor unit Cb are arranged in a row and are located between the second side 12 of the PCB 1 and the discrete components. That is to say, the first commutation units and the second commutation units are symmetrically disposed on the PCB 1, the first commutation units are disposed on the right half of the PCB 1 and the second commutation units are disposed on the left half of the PCB 1. The first capacitor unit Ca may include a plurality of first capacitors C1, the second capacitor unit Cb may include a plurality of second capacitors C2, and the plurality of first capacitors C1 and the plurality of second capacitors C2 are arranged in a row on the PCB 1. Specifically, the first part of the plurality of first capacitors C1 may be arranged in a row on the PCB 1, and the second part of the plurality of first capacitors C1 and the plurality of second capacitors C2 may be alternately arranged in a row on the PCB 1. The first part of the plurality of first capacitors C1 are close to the first discrete component Q1 and the second discrete component Q2 in each first commutation unit connected thereto, so that a commutation loop formed by the first discrete component Q1 and the second discrete component Q2 in each first commutation unit and the corresponding first capacitor C1 (as close as possible to the first commutation unit) has a minimum path; and the second part of the plurality of first capacitors C1 and the plurality of second capacitors C2 are close to the third discrete component Q3 and the fourth discrete component Q4 in each second commutation unit connected thereto, so that a commutation loop formed by the third discrete component Q3 and the fourth discrete component Q4 in each second commutation unit and the corresponding second capacitor C2 and the corresponding first capacitor C1 (as close as possible to the second commutation unit) has a minimum path.

As shown in FIG. 5B, the fourth embodiment of the power converter of the present application is different from the first embodiment in that the power converter further includes a plurality of second commutation units and a second capacitor unit Cb disposed on the PCB 1, wherein capacitor in the second capacitor unit Cb, for example, is input capacitor or DC bus capacitor, and each of the second commutation units includes a third discrete component Q3 and a fourth discrete component Q4. The second capacitor unit Cb is electrically coupled to a first end of the third discrete component Q3 and a second end of the fourth discrete component Q4 in each second commutation unit, respectively, and the first capacitor unit Ca is electrically coupled to a second end of the third discrete component Q3 and a first end of the fourth discrete component Q4 in each second commutation unit, respectively; and the first capacitor unit Ca is electrically coupled to first end of the first discrete component Q1 and second end of the second discrete component Q2 in each first commutation unit, respectively; wherein capacitor in the first capacitor unit, for example, is flying capacitor. The first capacitor unit and the first discrete component Q1 and the second discrete component Q2 in the plurality of first commutation units form commutation loops 1, the second capacitors C2, the first capacitors C1 and the third discrete components Q3 and the fourth discrete components Q4 in the plurality of second commutation units form commutation loops 2, the commutation loops in the plurality of first commutation units are symmetrical, and the commutation loops in the plurality of second commutation units are symmetrical, so that the current balance on the discrete components connected in parallel is excellent.

The third discrete components Q3 in the plurality of second commutation units are electrically coupled in parallel, and the fourth discrete components Q4 in the plurality of second commutation units are electrically coupled in parallel. An inductor L and an output capacitor C0 may be sequentially coupled in series to an output end of the power converter.

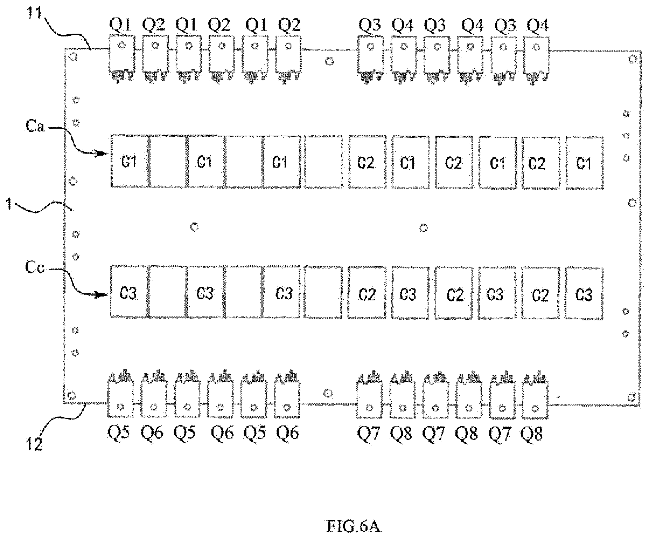

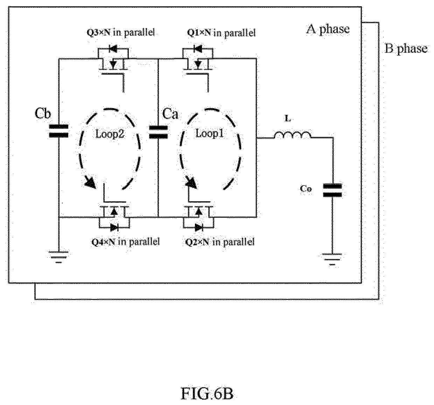

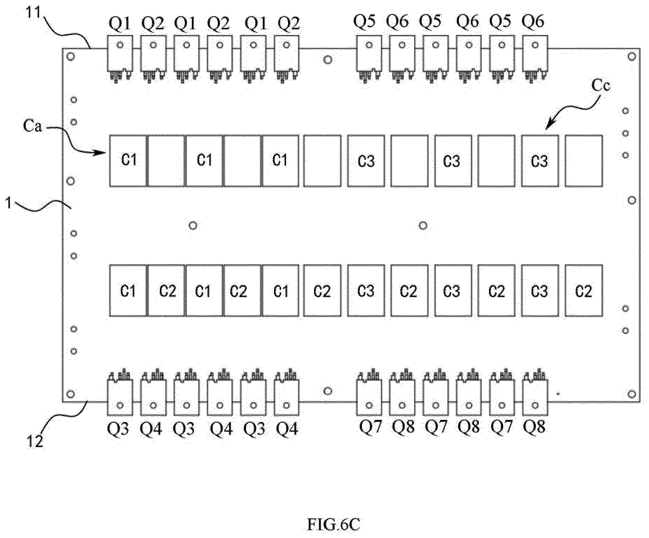

Referring to FIGS. 6A, 6B, and 6C, FIG. 6A is a structural schematic diagram of a fifth embodiment of a power converter of the present application, FIG. 6B is a topology diagram of the fifth embodiment of the power converter of the present application, and FIG. 6C is another structural schematic diagram of the fifth embodiment of the power converter of the present application.

As shown in FIG. 6A, the fifth embodiment of the power converter of the present application is different from the fourth embodiment in that the fifth embodiment of the power converter further includes a plurality of third commutation units, third capacitor unit Cc and a plurality of fourth commutation units disposed on the PCB 1, wherein capacitor in the third capacitor unit Cc, for example, may be flying capacitor, the third commutation units have basically the same structure as that of the first commutation units and the fourth commutation units have substantively the same structure as that of the second commutation units. The third commutation units and the fourth commutation units are symmetrically arranged with the first commutation units and the second commutation units.

In this embodiment, the first commutation units and the second commutation units form a phase A of the power converter, and the third commutation units and the fourth commutation units form a phase B of the power converter, wherein the phases A and B are connected in parallel.

As shown in FIG. 6A, each third commutation unit includes a fifth discrete component Q5 and a sixth discrete component Q6. The fifth discrete components Q5 and the sixth discrete components Q6 in the plurality of third commutation units are arranged in a row. The fifth discrete components Q5 and the sixth discrete components Q6 in the plurality of third commutation units may be alternately arranged in a row, and the third capacitor unit and the fifth discrete component Q5 and the sixth discrete component Q6 in each third commutation unit form a commutation loop.

In this embodiment, the fifth discrete components Q5 in the plurality of third commutation units are electrically coupled in parallel and the sixth discrete components Q6 in the plurality of third commutation units are electrically coupled in parallel.

Each fourth commutation unit includes a seventh discrete component Q7 and an eighth discrete component Q8. The seventh discrete components Q7 and the eighth discrete components Q8 in the plurality of fourth commutation units are arranged in a row. The seventh discrete components Q7 and the eighth discrete components Q8 in the plurality of fourth commutation units may be alternately arranged in a row, the second capacitor unit, the third capacitor unit and the seventh discrete component Q7 and the eighth discrete component Q8 in each fourth commutation unit form a commutation loop.

In the fifth embodiment, the seventh discrete components Q7 in the plurality of fourth commutation units are electrically coupled in parallel and the eighth discrete components Q8 in the plurality of fourth commutation units are electrically coupled in parallel.

The first capacitor unit Ca includes a plurality of first capacitors C1, the second capacitor unit Cb includes a plurality of second capacitors C2, and the third capacitor unit Cc includes a plurality of third capacitors C3.

The first discrete components Q1 and the second discrete components Q2 in the plurality of first commutation units and the third discrete components Q3 and the fourth discrete components Q4 in the plurality of second commutation units are located on the first side 11 of the PCB 1, and the fifth discrete components Q5 and the sixth discrete components Q6 in the plurality of third commutation units and the seventh discrete components Q7 and the eighth discrete components Q8 in the plurality of fourth commutation units are located on the second side 12 of the PCB 1.

The first part and the second part of the plurality of first capacitors C1 and the first part of the plurality of second capacitors C2 are arranged in a row, the second part of the plurality of first capacitors C1 and the first part of the plurality of second capacitors C2 are alternately disposed, and the first part of the plurality of first capacitors C1 are close to the first discrete components Q1 and the second discrete components Q2 in the plurality of first commutation units, so that the first discrete component Q1 and the second discrete component Q2 in the each of the plurality of first commutation units and the corresponding first capacitor C1 (as close as possible to the first commutation unit) form minimum commutation loops.

The second part of the plurality of first capacitors C1 and the first part of the plurality of second capacitors C2 are close to the third discrete components Q3 and the fourth discrete components Q4 in the plurality of second commutation units, so that the third discrete components Q3 and the fourth discrete component Q4 in the each of the plurality of second commutation units, the corresponding first capacitor C1 and the corresponding second capacitor C2 (as close as possible to the second commutation unit) form a minimum commutation loop.

The first part and the second part of the plurality of third capacitors C3 and the second part of the plurality of second capacitors C2 are arranged in a row and the second part of the plurality of third capacitors C3 and the second part of the plurality of second capacitors C2 are alternately disposed.

The plurality of first capacitors C1 and the first part of the plurality of second capacitors C2 are disposed side by side with the plurality of third capacitors C3 and the second part of the plurality of second capacitors C2; and the first part of the plurality of third capacitors C3 are close to the fifth discrete components Q5 and the sixth discrete components Q6 in the plurality of third commutation units, so that the fifth discrete component Q5 and the sixth discrete component Q6 in the each of the plurality of third commutation units and the corresponding third capacitor C3 (as close as possible to the third commutation unit) form a minimum commutation loop.

The second part of the plurality of third capacitors C3 and the second part of the plurality of second capacitors C2 are close to the seventh discrete components Q7 and the eighth discrete components Q8 in the plurality of fourth commutation units, so that the seventh discrete component Q7 and the eighth discrete component Q8 in the each of the plurality of fourth commutation units, the corresponding second capacitor C2, and the corresponding third capacitor C3 forms a minimum commutation loop.

As shown in FIG. 6C, the first capacitor unit Ca includes a plurality of first capacitors C1; the second capacitor unit Cb includes a plurality of second capacitors C2; and the third capacitor unit Cc includes a plurality of third capacitors C3.

The first discrete components Q1 and the second discrete components Q2 in the plurality of first commutation units and the fifth discrete components Q5 and the sixth discrete components Q6 in the plurality of third commutation units are located on the first side 11 of the PCB 1, and the third discrete components Q3 and the fourth discrete components Q4 in the plurality of second commutation units and the seventh discrete components Q7 and the eighth discrete components Q8 in the plurality of fourth commutation units are located on the second side 12 of the PCB 1.

The first part of the plurality of first capacitors C1 and the first part of the plurality of third capacitors C3 are arranged in a row, and the first part of the plurality of first capacitors C1 are close to the first discrete components Q1 and the second discrete components Q2 in the plurality of first commutation units, so that the first discrete component Q1 and the second discrete component Q2 in the each of the plurality of first commutation units and the corresponding first capacitor C1 (as close as possible to the first commutation unit) form a minimum commutation loop.

The first part of the plurality of third capacitors C3 are close to the fifth discrete components Q5 and the sixth discrete components Q6 in the plurality of third commutation units, so that the fifth discrete component Q5 and the sixth discrete component Q6 in the each of the plurality of third commutation units and the corresponding third capacitor C3 (as close as possible to the third commutation unit) form a minimum commutation loop.

The second part of the plurality of first capacitors C1, the second part of the plurality of third capacitors C3, and the first part and the second part of the plurality of second capacitors C2 are arranged in a row; and the first part of the plurality of first capacitors C1 and the first part of the plurality of third capacitors C3 are disposed side by side with the second part of the plurality of first capacitors C1, the plurality of second capacitors C2 and the second part of the plurality of third capacitors C3. And the second part of the plurality of first capacitors C1 and the first part of the plurality of second capacitors C2 are alternately disposed, and the second part of the plurality of third capacitors C3 and the second part of the plurality of second capacitors C2 are alternately disposed.

The second part of the plurality of first capacitors C1 and the first part of the plurality of second capacitors C2 are close to the third discrete components Q3 and the fourth discrete components Q4 in the plurality of second commutation units, so that the third discrete component Q3 and the fourth discrete component Q4 in the each of the plurality of second commutation units, the corresponding first capacitor C1and the corresponding second capacitor C2 (as close as possible to the second commutation unit) form a minimum commutation loop.

The second part of the plurality of third capacitors C3 and the second part of the plurality of second capacitors C2 are close to the seventh discrete components Q7 and the eighth discrete components Q8 in the plurality of fourth commutation units, so that the seventh discrete component Q7 and the eighth discrete component Q8 in the each of the plurality of fourth commutation units, the corresponding second capacitor C2and the corresponding third capacitor C3 (as close as possible to the fourth commutation unit) form a minimum commutation loop.

Referring to a phase A topology shown in FIG. 6B, a phase B topology is substantively the same as the phase A topology. In detail, each of the third commutation units includes a fifth discrete component Q5 and a sixth discrete component Q6, a second end of the fifth discrete component Q5 is electrically coupled to a first end of the sixth discrete component Q6, and the third capacitor unit Cc is electrically coupled to a first end of the fifth discrete component Q5 and a second end of the sixth discrete component Q6 in each of the third commutation units, respectively; and wherein the fifth discrete components Q5 and the sixth discrete components Q6 in the plurality of third commutation units are arranged in a row, and the fifth discrete component Q5 and the sixth discrete component Q6 in each of the third commutation units form a commutation loop together with the third capacitor unit Cc.

Each of the fourth commutation units includes a seventh discrete component Q7 and an eighth discrete component Q8, the third capacitor C3 is electrically coupled to a second end of the seventh discrete component Q7 and a first end of the eighth discrete component Q8 in each of the fourth commutation units, respectively, and the second capacitor C2 is electrically coupled to a first end of the seventh discrete component Q7 and a second end of the eighth discrete component Q8 in each of the fourth commutation units, respectively; wherein the seventh discrete components Q7 and the eighth discrete components Q8 in the plurality of fourth commutation units are arranged in a row, and the seventh discrete component Q7 and the eighth discrete component Q8 in each of the fourth commutation units form a commutation loop together with the second capacitor unit Cb, and the third capacitor unit Cc.

Other structures of the fifth embodiment of the power converter of the present application are substantively the same as those of the fourth embodiment, and will not be repeated here.

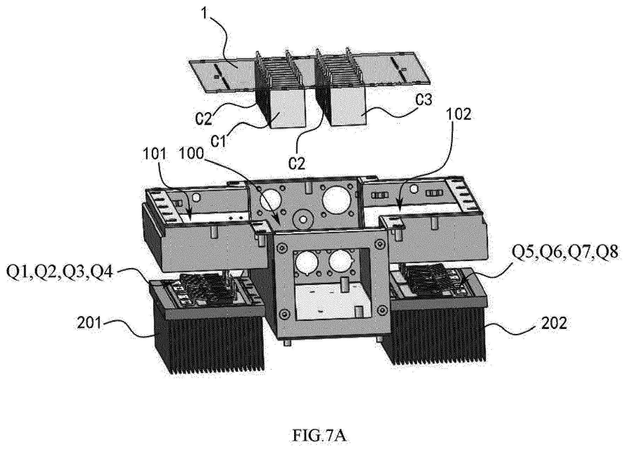

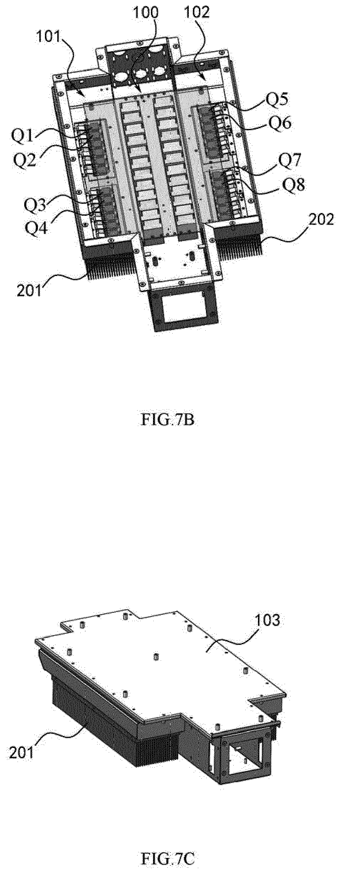

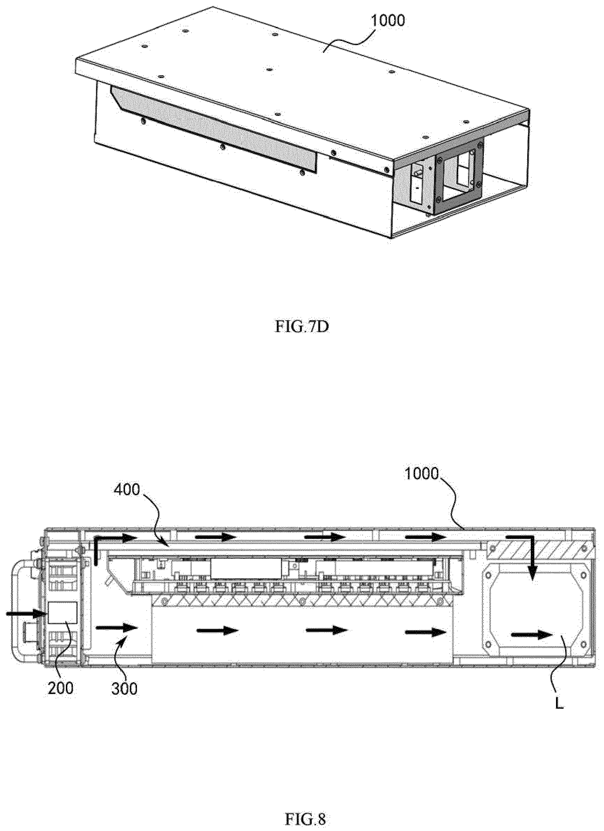

Referring to FIG. 7A, FIG. 7A is an exploded perspective view of a power converter of the present application; FIG. 7B is an assembly perspective view of a power converter of the present application; FIG. 7C is a perspective view of an enclosed cavity in a power converter of the present application; and FIG. 7D is a perspective view of a protective housing in a power converter of the present application. As shown in FIGS. 7A and 7B, a power converter of the present application further includes an enclosed cavity. The enclosed cavity includes a middle chamber 100, a first side chamber 101 connected to the middle chamber 100 and a second side chamber 102 connected to the middle chamber 100. The first side chamber 101 and the second side chamber 102 are located on opposite sides of the middle chamber 100. A first heat sink 201 is installed at the bottom of the first side chamber 101; and a second heat sink 202 is installed at the bottom of the second side chamber 102.

Referring to FIGS.7A and 6A, in the power converter of the present application, all capacitors include first capacitors C1, second capacitors C2 and third capacitors C3 which are accommodated in the middle chamber 100; all discrete components on one side of the capacitors include first discrete components Q1, second discrete components Q2, third discrete components Q3 and fourth discrete components Q4 which are accommodated in the first side chamber 101; and all discrete components on the other side of the capacitors include fifth discrete components Q5, sixth discrete components Q6, seventh discrete components Q7, and eighth discrete components Q8 which are accommodated in the second side chamber 102. Further, surfaces of bodies of the first discrete components Q1, the second discrete components Q2, the third discrete components Q3, and the fourth discrete components Q4 are attached to the first heat sink 201, and surfaces of bodies of the fifth discrete components Q5, the sixth discrete components Q6, the seventh discrete components Q7, and the eighth discrete components Q8 are attached to the second heat sink 202.

A cover plate 103 is hermetically provided on top openings of the middle chamber 100, the first side chamber 101, and the second side chamber 102.

In the present application, the enclosed chamber, which may achieve IP65 protective level, is formed by the cover plate 103, the middle chamber 100, the first side chamber 101, the second side chamber 102, the first heat sink 201, and the second heat sink 202 together.

As shown in FIG. 7D, a protective housing 1000 may be disposed outside the enclosed cavity.

Referring to FIG. 7C, in the power converter of the present application, all capacitors include first capacitors C1, second capacitors C2, and third capacitors C3 which are accommodated in the middle chamber 100; all discrete components on one side of the capacitors include first discrete components Q1, second discrete components Q2, fifth discrete components Q5 and sixth discrete components Q6 which are accommodated in the first side chamber 101; and all discrete components on the other side of the capacitors include third discrete components Q3, fourth discrete components Q4, seventh discrete components Q7 and eighth discrete components Q8 which are accommodated in the second side chamber 102. Further, surfaces of bodies of the first discrete components Q1, the second discrete components Q2, the fifth discrete components Q5 and the sixth discrete components Q6 are attached to the first heat sink 201, and surfaces of bodies of the third discrete components Q3, the fourth discrete components Q4, the seventh discrete components Q7 and the eighth discrete components Q8 are attached to the second heat sink 202.

As shown in FIGS. 7D and 8, a front end of the enclosed cavity is spaced apart from a front end of the protective housing 1000 by a distance. Cooling fans 200 may be installed in front of the middle chamber 100 of the enclosed cavity. Inductors L are installed behind the enclosed cavity. A portion of cooling air generated by the cooling fan 200 is passed to the first heat sink 201, the second heat sink 202 and the inductors L by the primary air duct 300, and the other portion of the cooling air is passed to the PCB 1 by the secondary air duct 400. The power converter of the present application not only has a higher protective level, but also has excellent heat dissipation performance.

In some other embodiments, the enclosed cavity includes a middle chamber 100, a side chamber such as a first side chamber 101 which is connected to middle chamber 100, and a heat sink such as a first heat sink 101. A cover plate 103 is provided on opening covers at the top of the middle chamber 100 and the first side chamber 101.

In the embodiment of the power converter shown in FIG. 2A, all of the first capacitors C1 are accommodated in the middle chamber 100, and all of the first discrete components Q1 and the second discrete components Q2 are accommodated in the first side chamber 101.

In the embodiments of the application, terms such as "installation", "connection", "connecting", "fixing" should be understood in a broad sense. For example, "connection" may be a fixed connection, a detachable connection, or an integral connect; "connecting" may be direct connection, or indirect connection through an intermediary. For those of ordinary skill in the art, the specific meanings of the above-described terms in the embodiments of the application may be understood according to the specific situations.

In the description of the embodiments of the application, it should be understood that orientations or positional relationships indicated by terms such as "on", "below", "left", and "right". are orientations or positional relationships shown in the figures, only for convenience of describing the embodiments of the application and simplified description thereof, rather than indicating or implying that the referred devices or units must have a specific direction, be constructed and operated in a specific orientation, and therefore it should not be construed as limitations on the embodiments of the application.

In the description of this specification, the description of terms such as "one embodiment", "some embodiments", "specific embodiment" mean that specific features, structures, materials or characters described in conjunction with the embodiments or examples are included in at least one embodiment or example of the embodiments of the application. In this specification, the schematic expression of the above-described terms do not necessarily refer to the same embodiment or example. Furthermore, the described specific features, structures, materials or characters may be combined in a suitable manner in any one or more embodiments or examples.

The above-described are only preferred embodiments of the embodiments of the application, and are not restrictive of the embodiments of the application. For those skilled in the art, the embodiments of the application may have various modifications and changes. Any modifications, equivalent replacements, changes, etc. made within the spirit and principle of the embodiments of the application should be included in the protection scope of the embodiments of the application.

## Claims

1. A power converter, comprising:
a printed circuit board, PCB, (1) having a first side (11) and a second side (12) opposite one another;
a plurality of first commutation units disposed on the PCB (1), each of the first commutation units comprising a first discrete component (Q1) and a second discrete component (Q2), a second end of the first discrete component (Q1) being electrically coupled to a first end of the second discrete component (Q2); and
a first capacitor unit (Ca) disposed on the PCB (1), the first capacitor unit (Ca) being electrically coupled to a first end of the first discrete component (Q1) and a second end of the second discrete component (Q2) in each of the plurality of first commutation units, respectively,
wherein the first discrete components (Q1) and the second discrete components (Q2) in the plurality of first commutation units are arranged in a row, and the first discrete component (Q1) and the second discrete component (Q2) in each of the first commutation units forms a commutation loop together with the first capacitor unit (Ca).

2. The power converter of claim 1, wherein the first discrete components (Q1) in the plurality of first commutation units are electrically coupled in parallel, and the second discrete components (Q2) in the plurality of first commutation units are electrically coupled in parallel, wherein the first discrete components (Q1) and the second discrete components (Q2) in the plurality of first commutation units are alternately arranged in a row, and the first discrete components (Q1) and the second discrete components (Q2) in the plurality of first commutation units are located on the first side (11) of the PCB (1).

3. The power converter of claim 1, further comprising:
a plurality of second commutation units disposed on the PCB (1), the plurality of second commutation units and the plurality of first commutation units being symmetrically disposed, each of the second commutation units comprising a third discrete component (Q3) and a fourth discrete component (Q4); a second end of the third discrete component (Q3) being electrically coupled to a first end of the fourth discrete component (Q4); a first end of the third discrete component (Q3) in each of the plurality of second commutation units being electrically coupled to the first end of the first discrete component (Q1) in each of the plurality of first commutation units, and a second end of the fourth discrete component (Q4) in each of the plurality of second commutation units being electrically coupled to the second end of the second discrete component (Q2) in each of the plurality of first commutation units, wherein the third discrete components (Q3) and the fourth discrete components (Q4) in the plurality of second commutation units are arranged in a row, and the third discrete component (Q3) and the fourth discrete component (Q4) in each of the second commutation units form a commutation loop together with the first capacitor unit (Ca).

4. The power converter of claim 1, further comprising:
a plurality of second commutation units and second capacitor unit (Cb) disposed on the PCB (1); the plurality of second commutation units and the plurality of first commutation units being symmetrically disposed, each of the second commutation units comprising a third discrete component (Q3) and a fourth discrete component (Q4); a second end of the third discrete component (Q3) being electrically coupled to a first end of the fourth discrete component (Q4); the second capacitor unit (Cb) being electrically coupled to a first end of the third discrete component (Q3) and a second end of the fourth discrete component (Q4) in each of the plurality of second commutation units, respectively; the first capacitor unit (Ca) and the second capacitor unit (Cb) being coupled in series, and the second end of the second discrete component (Q2) in each of the plurality of first commutation units being electrically coupled to the first end of the third discrete component (Q3) in each of the plurality of second commutation units; wherein the third discrete components (Q3) and the fourth discrete components (Q4) in the plurality of second commutation units are arranged in a row, and the third discrete component (Q3) and the fourth discrete component (Q4) in each of the second commutation units form a commutation loop together with the second capacitor unit (Cb).

5. The power converter of claim 1, further comprising:
a plurality of second commutation units and a second capacitor unit (Cb) disposed on the PCB (1); each of the second commutation units comprising a third discrete component (Q3) and a fourth discrete component (Q4); a first end of the third discrete component (Q3) in each of the plurality of second commutation units being electrically coupled to a first end of the second capacitor unit (Cb), a second end of the third discrete component (Q3) in each of the plurality of second commutation units being electrically coupled to a first end of the first capacitor unit (Ca), a second end of the fourth discrete component (Q4) in each of the plurality of second commutation units being electrically coupled to a second end of the second capacitor unit (Cb), and a first end of the fourth discrete component (Q4) in each of the plurality of second commutation units being electrically coupled to a second end of the first capacitor unit (Ca); wherein the third discrete components (Q3) and the fourth discrete components (Q4) in the plurality of second commutation units are arranged in a row, and the third discrete component (Q3) and the fourth discrete component (Q4) in each of the second commutation units form a commutation loop together with the second capacitor unit (Cb) and the first capacitor unit (Ca).

6. The power converter of claim 3, 4 or 5, wherein the third discrete components (Q3) in the plurality of second commutation units are electrically coupled in parallel, the fourth discrete components (Q4) in the plurality of second commutation units are electrically coupled in parallel, and the third discrete components (Q3) and the fourth discrete components (Q4) in the plurality of second commutation units are alternately arranged in a row.

7. The power converter of claim 3, wherein the plurality of first commutation units are located on the first side (11) of the PCB (1), the plurality of second commutation units are located on the second side (12) of the PCB (1), and the first capacitor unit (Ca) is located between the first commutation units and the second commutation units, wherein the first capacitor unit (Ca) comprises a plurality of first capacitors and the plurality of first capacitors are arranged in two rows disposed side by side.

8. The power converter of claim 3, wherein the first discrete components (Q1) and the second discrete components (Q2) in the plurality of first commutation units, and the third discrete components (Q3) and the fourth discrete components (Q4) in the plurality of second commutation units are arranged in a row and located on the first side (11) of the PCB (1), and wherein the first capacitor unit (Ca) comprises a plurality of first capacitors, and the plurality of first capacitors are arranged in a row.

9. The power converter of claim 4 or 5, wherein the plurality of first commutation units are located on the first side (11) of the PCB (1), the plurality of second commutation units are located on the second side (12) of the PCB (1), and the first capacitor unit (Ca) and the second capacitor unit (Cb) are both located between the plurality of first commutation units and the plurality of second commutation units, wherein
the first capacitor unit (Ca) comprises a plurality of first capacitors; the second capacitor unit (Cb) comprises a plurality of second capacitors; the plurality of first capacitors are arranged in a row, the plurality of second capacitors are arranged in a row, and the plurality of first capacitors and the plurality of second capacitors are disposed side by side; wherein the plurality of first capacitors are close to the first commutation units, and the plurality of second capacitors are close to the second commutation units; or
the first capacitor unit (Ca) comprises a plurality of first capacitors; the second capacitor unit (Cb) comprises a plurality of second capacitors; a first part of the plurality of first capacitors are arranged in a row, a second part of the plurality of first capacitors and the plurality of second capacitors are alternately arranged in a row and are disposed side by side with the first part of the plurality of first capacitors; wherein the first part of the plurality of first capacitors are close to the first discrete components (Q1) and the second discrete components (Q2) in the first commutation units, and the second part of the plurality of first capacitors and the plurality of second capacitors are close to the third discrete components (Q3) and the fourth discrete components (Q4) in the second commutation units.

10. The power converter of claim 4 or 5, wherein the first capacitor unit (Ca) and the second capacitor unit (Cb) are arranged in a row, and the first discrete components (Q1) and the second discrete components (Q2) in the first commutation units and the third discrete components (Q3) and the fourth discrete components (Q4) in the plurality of second commutation units are arranged in a row and located on the first side (11) of the PCB (1), wherein
the first capacitor unit (Ca) comprises a plurality of first capacitors, the second capacitor unit (Cb) comprises a plurality of second capacitors; the plurality of first capacitors and the plurality of second capacitors are arranged in a row, wherein the plurality of first capacitors are close to the first discrete components (Q1) and the second discrete components (Q2) in the first commutation units, and the plurality of second capacitors are close to the third discrete components (Q3) and the fourth discrete components (Q4) in the plurality of second commutation units; or
the first capacitor unit (Ca) comprises a plurality of first capacitors, the second capacitor unit (Cb) comprises a plurality of second capacitors; the plurality of first capacitors and the plurality of second capacitors are arranged in a row, wherein a first part of the plurality of first capacitors are close to the first discrete components (Q1) and the second discrete components (Q2) in the first commutation units, and a second part of the plurality of first capacitors and the plurality of second capacitors are alternately arranged in a row and close to the third discrete components (Q3) and the fourth discrete components (Q4) in the plurality of second commutation units.

11. The power converter of claim 5, further comprising a plurality of third commutation units, a plurality of fourth commutation units and a third capacitor unit (Cc) disposed on the PCB (1); the plurality of third commutation units and the plurality of fourth commutation units being symmetrically disposed with the plurality of first commutation units and the plurality of second commutation units;
each of the third commutation units comprising a fifth discrete component (Q5) and a sixth discrete component (Q6), a second end of the fifth discrete component (Q5) being electrically coupled to a first end of the sixth discrete component (Q6), the third capacitor unit (Cc) being electrically coupled to a first end of the fifth discrete component (Q5) and a second end of the sixth discrete component (Q6) in each of the plurality of third commutation units, respectively; wherein the fifth discrete components (Q5) and the sixth discrete components (Q6) in the plurality of third commutation units are arranged in a row, and the fifth discrete component (Q5) and the sixth discrete component (Q6) in each of the third commutation units form a commutation loop together with the third capacitor unit (Cc);
each of the fourth commutation units comprises a seventh discrete component (Q7) and an eighth discrete component (Q8), the third capacitor unit (Cc) is electrically coupled to a second end of the seventh discrete component (Q7) and a first end of the eighth discrete component (Q8) in each of the plurality of fourth commutation units, respectively, and the second capacitor unit (Cb) is electrically coupled to a first end of the seventh discrete component (Q7) and a second end of the eighth discrete component (Q8) in each of the plurality of fourth commutation units, respectively; wherein the seventh discrete components (Q7) and the eighth discrete components (Q8) in the plurality of fourth commutation units are arranged in a row, and the seventh discrete component (Q7) and the eighth discrete component (Q8) in each of the fourth commutation units form a commutation loop together with the second capacitor unit (Cb) and the third capacitor unit (Cc).

12. The power converter of claim 11, wherein the fifth discrete components (Q5) in the plurality of third commutation units are electrically coupled in parallel, the sixth discrete components (Q6) in the plurality of third commutation units are electrically coupled in parallel, the seventh discrete components (Q7) in the plurality of fourth commutation units are electrically coupled in parallel and the eighth discrete components (Q8) in the plurality of fourth commutation units are electrically coupled in parallel, wherein the fifth discrete components (Q5) and the sixth discrete components (Q6) in the plurality of third commutation units are alternately arranged in a row; and the seventh discrete components (Q7) and the eighth discrete components (Q8) in the plurality of fourth commutation units are alternately arranged in a row.

13. The power converter of claim 11, wherein the first capacitor unit (Ca) comprises a plurality of first capacitors; the second capacitor unit (Cb) comprises a plurality of second capacitors; and the third capacitor unit (Cc) comprises a plurality of third capacitors, wherein the first discrete components (Q1) and the second discrete components (Q2) in the plurality of first commutation units, and the third discrete components (Q3) and the fourth discrete components (Q4) in the plurality of second commutation units are located on the first side (11) of the PCB (1); the fifth discrete components (Q5) and the sixth discrete components (Q6) in the plurality of third commutation units, and the seventh discrete components (Q7) and the eighth discrete components (Q8) in the plurality of fourth commutation units are located on the second side (12) of the PCB (1); a first part and a second part of the plurality of first capacitors and a first part of the plurality of second capacitors are arranged in a row; the second part of the plurality of first capacitors and the first part of the plurality of second capacitors are alternately disposed; and the first part of the plurality of first capacitors are close to the first discrete components (Q1) and the second discrete components (Q2) in the plurality of first commutation units, the second part of the plurality of first capacitors and the first part of the plurality of second capacitors are close to the third discrete components (Q3) and the fourth discrete components (Q4) in the plurality of second commutation unit; a first part and a second part of the plurality of third capacitors and a second part of the plurality of second capacitors are arranged in a row; the second part of the plurality of third capacitors and the second part of the plurality of second capacitors are alternately disposed; the first part of the plurality of third capacitors are close to the fifth discrete components (Q5) and the sixth discrete components (Q6) in the plurality of third commutation units; and the second part of the plurality of third capacitors and the second part of the plurality of second capacitors are close to the seventh discrete components (Q7) and the eighth discrete components (Q8) in the plurality of fourth commutation units,
the power converter further comprising an enclosed cavity, the enclosed cavity comprising a middle chamber (100), a first side chamber, and a second side chamber (102); the first side chamber (101) and the second side chamber (102)being located on both sides of the middle chamber (100), and being connected to the middle chamber (100); wherein the plurality of first capacitors, the plurality of second capacitors and the plurality of third capacitors are accommodated in the middle chamber (100); the first discrete components (Q1) and the second discrete components (Q2) in the plurality of first commutation units, and the third discrete components (Q3) and the fourth discrete components (Q4) in the plurality of second commutation units are accommodated in the first side chamber (101); the fifth discrete components (Q5) and the sixth discrete components (Q6) in the plurality of third commutation units and the seventh discrete components (Q7) and the eighth discrete components (Q8) in the plurality of fourth commutation units are accommodated in the second side chamber (102); the first side chamber (101) is provided with a first heat sink (201), and the second side chamber (102) is provided with a second heat sink (202).

14. The power converter of claim 11, wherein the first capacitor unit (Ca) comprises a plurality of first capacitors; the second capacitor unit (Cb) comprises a plurality of second capacitors; and the third capacitor unit (Cc) comprises a plurality of third capacitors; wherein the plurality of first commutation units and the plurality of third commutation units are located on the first side (11) of the PCB (1), the plurality of second commutation units and the plurality of fourth commutation units are located on the second side (12) of the PCB (1); a first part of the plurality of first capacitors and a first part of the plurality of third capacitors are arranged in a row; the first part of the plurality of first capacitors are close to the first discrete components (Q1) and the second discrete components (Q2) in the plurality of first commutation units; and the first part of the plurality of third capacitors are close to the fifth discrete components (Q5) and the sixth discrete components (Q6) in the plurality of third commutation units; a second part of the plurality of first capacitors and a first part of the plurality of second capacitors are alternately arranged in a row; a second part of the plurality of third capacitors and the second part of the plurality of second capacitors are alternately arranged in a row; and the second part of the plurality of first capacitors, the first part of the plurality of second capacitors, the second part of the plurality of third capacitors, and the second part of the plurality of second capacitors are disposed side by side with the first part of the plurality of first capacitors and the first part of the plurality of third capacitors; the second part of the plurality of first capacitors and the first part of the plurality of second capacitors are close to the third discrete components (Q3) and the fourth discrete components (Q4) in the plurality of second commutation units; and the second part of the plurality of third capacitors and the second part of the plurality of second capacitors are close to the seventh discrete components (Q7) and the eighth discrete components (Q8) in the plurality of fourth commutation units,
the power converter further comprising an enclosed cavity, the enclosed cavity comprising a middle chamber (100), a first side chamber (101), and a second side chamber (102); the first side chamber (101) and the second side chamber (102) being located on both sides of the middle chamber (100), and connected to the middle chamber (100); wherein the plurality of first capacitors, the plurality of second capacitors and the plurality of third capacitors are accommodated in the middle chamber (100); the first discrete components (Q1) and the second discrete components (Q2) in the plurality of first commutation units, and the fifth discrete components (Q5) and the sixth discrete components (Q6) in the plurality of third commutation units are accommodated in the first side chamber (101); the third discrete components (Q3) and the fourth discrete components (Q4) in the plurality of second commutation units, and the seventh discrete components (Q7) and the eighth discrete components (Q8) in the plurality of fourth commutation units are accommodated in the second side chamber (102); the first side chamber (101) is provided with a first heat sink (201), and the second side chamber (102) is provided with a second heat sink (202).

15. The power converter of claim 1, further comprising an enclosed cavity, the enclosed cavity comprising a middle chamber (100) and a first side chamber (101) connected to the middle chamber (100); the first capacitor unit (Ca) being accommodated in the middle chamber (100), the first discrete components (Q1) and the second discrete components (Q2) being accommodated in the first side chamber (101), and the first side chamber (101)being provided with a first heat sink (201).
